# EUROPEAN PATENT APPLICATION

(11) **EP 4 739 046 A1**
(43) Date of publication of application: **06.05.2026**
(21) Application number: 25212662.8
(22) Date of filing: 31.10.2025
(51) Int. Cl.: H10H 29/34

(54) **DISPLAY DEVICE AND ELECTRONIC DEVICE**

(30) Priority: 01.11.2024 KR 20240153441
(71) Applicant: Samsung Display Co., Ltd., Yongin-si, Gyeonggi-do (KR)
(72) Inventor: Lee, Jongwon, Yongin-si, Gyeonggi-do (KR); Kang, Jae Woong, Yongin-si, Gyeonggi-do (KR); Jang, Jin Hyuk, Yongin-si, Gyeonggi-do (KR)
(74) Representative: Gulde & Partner

(57) **Abstract**

A display device includes: a substrate; and a first light emitting diode unit, a second light emitting diode unit, and a third light emitting diode unit that are disposed above the substrate, and the first light emitting diode unit includes at least one first light emitting diode emitting a first color light, the second light emitting diode unit includes at least one second light emitting diode emitting a second color light different from the first color light, the third light emitting diode unit includes at least one third light emitting diode emitting a third color light different from the first color light and the second color light, and a planar size of the at least one third light emitting diode is greater than a planar size of the at least one first light emitting diode and a planar size of the at least one second light emitting diode.

## Description

### BACKGROUND

### 1. Technical Field

Embodiments relate to a display device and an electronic device. The electronic device may include the display device.

### 2. Description of the Related Art

A display device includes pixels that are units for displaying an image. Each pixel may include a pixel circuit portion and a light emitting portion connected to the pixel circuit portion. The light emitting portion may be implemented in various forms, and for example, it may include a light emitting diode that is a light emitting element. The light emitting diode may have various sizes, and an ultra-small light emitting diode of the micro scale or nano scale using a Group II-VI compound semiconductor material or a Group III-V compound semiconductor material has recently been developed.

The light emitting diode may be directly formed on a substrate included in the display device, or may be installed on the substrate in a form of a chip. The light emitting diode may emit light of one of several basic colors.

The pixel circuit portion for driving the light emitting diode may be integrated on the substrate, or may be included in a light emitting diode chip. The pixel circuit portion may include a plurality of transistors and at least one capacitor. The pixel circuit portion may control an amount of a driving current transferred to the light emitting diode so that each pixel emits light of a desired luminance.

### SUMMARY

Embodiments are intended to provide a display device and an electronic device capable of improving both luminance efficiency and reliability of light emitting diodes.

However, embodiments are not limited to those set forth herein. The above and other embodiments will become more apparent to one of ordinary skill in the art to which the disclosure pertains by referencing the detailed description of the disclosure given below.

A display device according to an embodiment includes: a substrate; and a first light emitting diode unit, a second light emitting diode unit, and a third light emitting diode unit that are disposed above the substrate, and the first light emitting diode unit includes at least one first light emitting diode emitting a first color light, the second light emitting diode unit includes at least one second light emitting diode emitting a second color light different from the first color light, the third light emitting diode unit includes at least one third light emitting diode emitting a third color light different from the first color light and the second color light, and a planar size of the at least one third light emitting diode is greater than a planar size of the at least one first light emitting diode and a planar size of the at least one second light emitting diode.

A shortest width of the at least one third light emitting diode in a plan view may be greater than a shortest width of the at least one first light emitting diode in the plan view and a shortest width of the at least one second light emitting diode in the plan view.

A shortest width of the at least one third light emitting diode may be greater than or equal to a reference size, and at least one of a shortest width of the at least one first light emitting diode and a shortest width of the at least one second light emitting diode may be less than the reference size.

The reference size may be within a range of about 3 micrometers to about 5 micrometers.

The shortest width of the at least one third light emitting diode may be less than about 10 micrometers.

At least one of the number of the at least one first light emitting diode included in the first light emitting diode unit and the number of the at least one second light emitting diode included in the second light emitting diode unit may be greater than the number of the at least one third light emitting diode included in the third light emitting diode unit.

The display device may further include a driving circuit portion that is disposed between each of the first light emitting diode unit, the second light emitting diode unit, and the third light emitting diode unit and the substrate.

The display device may further include a pixel circuit portion that is electrically connected to at least one first electrode of the at least one first light emitting diode, the at least one second light emitting diode, and the at least one third light emitting diode, and the pixel circuit portion may include a plurality of transistors.

The driving circuit portion may include the pixel circuit portion.

The pixel circuit portion may be disposed between the substrate and the driving circuit portion.

A planar shape of at least one of the at least one first light emitting diode, the at least one second light emitting diode, and the at least one third light emitting diode may be a circle or a rectangle.

A display device according to another embodiment includes: a substrate; and a first light emitting diode unit and a second light emitting diode unit that are disposed above the substrate, and the first light emitting diode unit includes at least one green-light emitting diode, the second light emitting diode unit includes at least one blue-light emitting diode, a shortest width of the second light emitting diode in a plan view is about 3 micrometers or more, and a shortest width of the at least one first light emitting diode in a plan view is less than about 3 micrometers.

A shortest width of the at least one first light emitting diode may be less than about 10 micrometers.

The number of the at least one first light emitting diode included in the first light emitting diode unit may be greater than the number of the at least one second light emitting diode included in the second light emitting diode unit.

The display device may further include a driving circuit portion that is disposed between each of the first light emitting diode unit and the second light emitting diode unit and the substrate.

The display device may further include a pixel circuit portion that is electrically connected to at least one first electrode of the at least one first light emitting diode and the at least one second light emitting diode, and the pixel circuit portion may include a plurality of transistors.

The driving circuit portion may include the pixel circuit portion.

The pixel circuit portion may be disposed between the substrate and the driving circuit portion.

An electronic device according to an embodiment includes: a substrate; and a first light emitting diode unit, a second light emitting diode unit, and a third light emitting diode unit that are disposed above the substrate, and the first light emitting diode unit includes at least one first light emitting diode emitting first color light, the second light emitting diode unit includes at least one second light emitting diode emitting second color light different from the first color light, the third light emitting diode unit includes at least one third light emitting diode emitting third color light different from the first color light and the second color light, and a planar size of the at least one third light emitting diode is greater than a planar size of the at least one first light emitting diode and a planar size of the at least one second light emitting diode.

A shortest width of the at least one third light emitting diode in a plan view may be greater than a shortest width of the at least one first light emitting diode in the plan view and a shortest width of the at least one second light emitting diode in the plan view.

According to the embodiments, both luminance efficiency and reliability of light emitting diodes of a display device may be improved.

### BRIEF DESCRIPTION OF THE DRAWINGS

FIG. 1 is a schematic block diagram of a display device according to an embodiment.
FIG. 2 is a schematic plan view of a display portion of the display device according to an embodiment.
FIG. 3 is a graph showing external quantum efficiency according to a planar size of a light emitting diode.
FIG. 4 is a graph showing a peak value of external quantum efficiency according to the planar size of the light emitting diode.
FIGS. 5A, 5B, and 5C are graphs showing external quantum efficiency according to a planar size of each of a red-light emitting diode, a green-light emitting diode, and a blue-light emitting diode.
FIGS. 6A, 6B, and 6C are graphs showing luminance according to the planar size of each of the red-light emitting diode, the green-light emitting diode, and the blue-light emitting diode.
FIG. 7 is a graph showing a change in normalized external quantum efficiency over time for a red-light emitting diode, a green-light emitting diode, and a blue-light emitting diode of various planar sizes.
FIG. 8 is a graph showing the change in normalized external quantum efficiency over time for a red-light emitting diode, a green-light emitting diode, and a blue-light emitting diode of various planar sizes.
Each of FIG. 9, FIG. 10, and FIG. 11 is a schematic plan view of a display portion of a display device according to an embodiment.
FIG. 12 is a schematic perspective view showing a cross-section of a light emitting diode according to an embodiment.
FIG. 13 is a schematic diagram of an equivalent circuit of a pixel of a display device according to an embodiment.
FIG. 14 is a schematic perspective view of a light emitting diode unit of a display device according to an embodiment.
Each of FIG. 15, FIG. 16, and FIG. 17 is a schematic cross-sectional view of a display device according to an embodiment.
FIG. 18 illustrates an example in which a display device according to an embodiment is applied to a mobile device.
FIG. 19 illustrates an example in which a display device according to an embodiment is applied to a display device for a vehicle.
FIG. 20 illustrates an example in which a display device according to an embodiment is applied to augmented reality glasses or virtual reality glasses.
FIG. 21 illustrates an example in which a display device according to an embodiment is applied to a wearable display device.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and reference characters refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

Embodiments have been disclosed herein, and although terms are employed, they are used and are to be interpreted in a generic and descriptive sense only and not for the purposes of limitation. In some instances, as would be apparent to one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the claims.

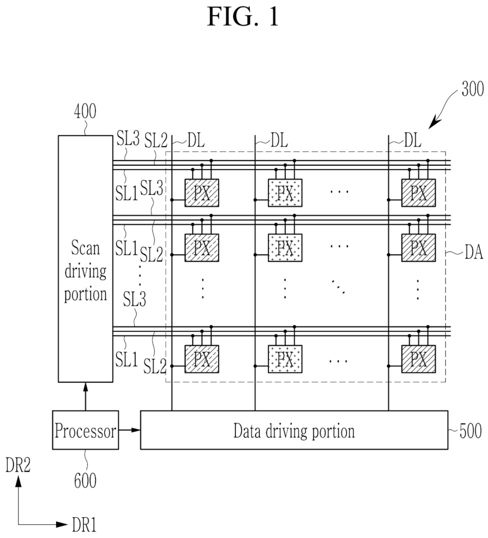

FIG. 1 is a schematic block diagram of a display device according to an embodiment.

Referring to FIG. 1, the display device 300 according to the embodiment is a light emitting display device including a light emitting element. The display device 300 may be implemented as a flexible display device, a rollable display device, a curved display device, a transparent display device, a mirror display device, or the like. The display device 300 may be included in an electronic device. The electronic device may include a display surface that displays an image on at least one surface, such as a smartphone, a television, a tablet PC, a mobile phone, an image phone, an electronic book reader, a desktop PC, a laptop PC, a netbook computer, a workstation, a server, a PDA, a portable multimedia player (PMP), an MP3 player, a medical device, a camera, or a wearable device.

Referring to FIG. 1, the display device 300 may include a display portion DA, a scan driving portion 400, a data driving portion 500, and a processor 600.

The display portion DA may include pixels PX disposed on a surface extending in the first direction DR1 and the second direction DR2, scan lines SL1, SL2, and SL3 (or gate lines) for transferring a scan signal to the pixels PX, and data lines DL for transferring a data signal to the pixels PX.

Each pixel PX may be a unit that displays an image, and may emit light with luminance corresponding to the data signal transferred through the data line DL in response to the scan signal transferred through the scan lines SL1, SL2, and SL3. An entire area where the pixels PX are disposed may be referred to as the display portion DA, and an area around the display portion DA may be referred to as a peripheral area. The display portion DA may display an image in a direction perpendicular to the first direction DR1 and the second direction DR2.

Each pixel PX may include a pixel circuit portion including transistors and a light emitting element.

The pixels PX may include pixels capable of emitting light of different colors. For example, the pixels PX may include a red pixel capable of emitting red light, a green pixel capable of emitting green light, a blue pixel capable of emitting blue light, and the like.

For example, each of the scan lines SL1, SL2, and SL3 may be elongated in the first direction DR1. A set of the first scan line SL1, the second scan line SL2, and the third scan line SL3 may be disposed for each pixel row to be connected to the pixels PX of the corresponding pixel row. The scan lines SL1, SL2, and SL3 may be connected to the scan driving portion 400 to receive the scan signal from the scan driving portion 400.

For example, the data line DL may be elongated in the second direction DR2. The data line DL may be connected to the data driving portion 500 to receive the data signal from the data driving portion 500.

The scan driving portion 400 may generate the scan signal (e.g., a gate signal with a turn-on voltage level that turns on a transistor), and may sequentially provide the scan signal to the scan lines SL1, SL2, and SL3. The scan driving portion 400 may include transistors disposed in a peripheral area of the display device 300 and integrated.

According to an embodiment, the display device 300 may further include a light emitting control driving portion that generates a light emitting control signal (e.g., the light emitting control signal with a turn-on voltage level that turns on a transistor).

The processor 600 may control the scan signal and the data signal provided to each pixel PX by controlling operations of the scan driving portion 400 and the data driving portion 500 based on data of an image to be displayed in the display portion DA.

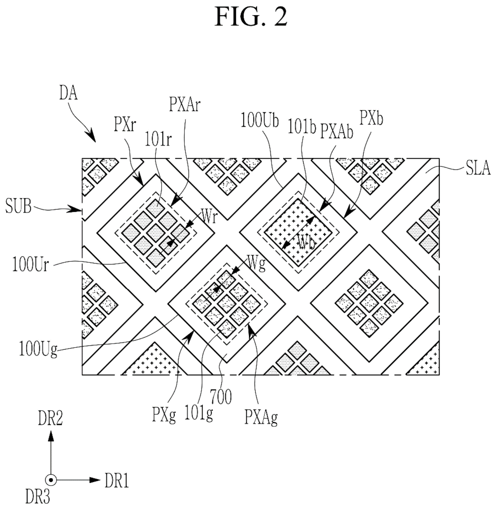

The display portion DA of the display device according to the embodiment will be described with reference to FIG. 1 and FIG. 2.

FIG. 2 is a schematic plan view of the display portion of the display device according to an embodiment.

Referring to FIG. 2, the display portion DA of the display device according to the embodiment may include a substrate SUB and a first pixel PXr, a second pixel PXg, and a third pixel PXb disposed above the substrate SUB. Each of the first pixel PXr, the second pixel PXg, and the third pixel PXb may be the pixel PX described above.

The substrate SUB may include any substrate material. According to an embodiment, the substrate SUB may include an insulating material such as a glass or a polymer resin. The polymer resin may include at least one of materials such as an acrylic resin, an epoxy resin, a phenolic resin, a polyamide resin, and a polyimide resin.

The first pixel PXr, the second pixel PXg, and the third pixel PXb may emit light of different colors. For example, the first pixel PXr may emit red light, the second pixel PXg may emit green light, and/or the third pixel PXb may emit blue light.

The first pixel PXr, the second pixel PXg, and the third pixel PXb may be disposed uniformly or regularly on a plane. For example, the first pixel PXr and the third pixel PXb may be alternately disposed in the first direction DR1 and the second direction DR2, the first pixel PXr and the second pixel PXg may be alternately disposed in a first diagonal direction that forms about 45 degrees with the first direction DR1 and the second direction DR2, and the third pixel PXb and the second pixel PXg may be alternately disposed in a second diagonal direction that forms about 45 degrees with the first direction DR1 and the second direction DR2 and is about perpendicular to the first diagonal direction.

The first pixel PXr may include a first light emitting diode unit 100Ur, the second pixel PXg may include a second light emitting diode unit 100Ug, and the third pixel PXb may include a third light emitting diode unit 100Ub. For example, each pixel PX may include a light emitting diode unit.

Each light emitting diode unit 100Ur, 100Ug, 100Ub is a light emitting element, and may include at least one light emitting diode and a driving circuit portion for driving the light emitting diode. For example, the first light emitting diode unit 100Ur may include at least one first light emitting diode 101r and a driving circuit portion 700 connected to the first light emitting diode 101r, the second light emitting diode unit 100Ug may include at least one second light emitting diode 101g and a driving circuit portion 700 connected to the second light emitting diode 101g, and the third light emitting diode unit 100Ub may include at least one third light emitting diode 101b and a driving circuit portion 700 connected to the third light emitting diode 101b.

The first light emitting diode 101r may emit a first color light that is red light, the second light emitting diode 101g may emit a second color light that is green light, and the third light emitting diode 101b may emit a third color light that is blue light. The first color light, the second color light, and the third color light may represent different colors.

At least one of the first light emitting diode 101r, the second light emitting diode 101g, and the third light emitting diode 101b may have a planar shape. For example, the planar shape may be a circle or a rectangle (e.g., a square). For example, referring to FIG. 2, the planar shape of each of the first light emitting diode 101r, the second light emitting diode 101g, and the third light emitting diode 101b may be a rectangle having a short side and a long side whose length is equal to or longer than the short side. FIG. 2 shows an example in which the planar shape of each of the first light emitting diode 101r, the second light emitting diode 101g, and the third light emitting diode 101b is a square shape.

According to an embodiment, the first light emitting diode 101r, the second light emitting diode 101g, and the third light emitting diode 101b may have the same planar shape. According to an embodiment, at least two of the first light emitting diode 101r, the second light emitting diode 101g, and the third light emitting diode 101b may have different planar shapes. For example, the planar shape of the third light emitting diode 101b may be a rectangle, and the planar shape of the first light emitting diode 101r or the second light emitting diode 101g may be a circle.

A planar size of the third light emitting diode 101b may be larger than a planar size of the first light emitting diode 101r and a planar size of the second light emitting diode 101g. Since the third light emitting diode 101b may be larger than a planar size of the first light emitting diode 101r and a planar size of the second light emitting diode 101g, the display device may improve both luminance efficiency and reliability of light emitting diodes. The planar size may be determined based on a length of a shortest side, a shortest width, or a planar area of each light emitting diode when viewed on a surface (or in a plan view) parallel to the first direction DR1 and the second direction DR2. The length of the shortest side may be said to be the shortest width. For example, referring to FIG. 2, a shortest width Wb of the third light emitting diode 101b may be greater than a shortest width Wr of the first light emitting diode 101r, and the shortest width Wb of the third light emitting diode 101b may be greater than a shortest width Wg of the second light emitting diode 101g.

The planar size of the first light emitting diode 101r may be the same as or different from the planar size of the second light emitting diode 101g. For example, the shortest width Wr of the first light emitting diode 101r may be the same as or different from the shortest width Wg of the second light emitting diode 101g.

The shortest width Wb of the third light emitting diode 101b may be greater than or equal to a reference size, and at least one of the shortest width Wr of the first light emitting diode 101r and the shortest width Wg of the second light emitting diode 101g may be less than the reference size. The reference size may be determined within a range of about 3 micrometers to about 5 micrometers, and if further limited, the reference size may be determined to be about 3 micrometers to about 4 micrometers or may be determined to be about 3 micrometers. For example, the shortest width Wb of the third light emitting diode 101b may be about 3 micrometers (or 5 micrometers) or more, and each of the shortest width Wr of the first light emitting diode 101r and the shortest width Wg of the second light emitting diode 101g may be less than about 3 micrometers. The shortest width Wb of the third light emitting diode 101b may be less than about 10 micrometers. If further limited, the shortest width Wb of the third light emitting diode 101b may be less than about 9 micrometers.

The first pixel PXr or the first light emitting diode unit 100Ur may include a first light emitting area PXAr, the second pixel PXg or the second light emitting diode unit 100Ug may include a second light emitting area PXAg, and the third pixel PXb or the third light emitting diode unit 100Ub may include a third light emitting area PXAb. Each of the light emitting areas PXAr, PXAg, and PXAb may be an area in which at least one light emitting diode included in each pixel entirely emits light, and may be an area surrounded by an outer boundary that is an envelope of an area in which at least one light emitting diode is disposed.

A planar shape of at least one of the first light emitting area PXAr, the second light emitting area PXAg, and the third light emitting area PXAb may be a rectangle (e.g. square) or a circle.

Areas of the first light emitting area PXAr, the second light emitting area PXAg, and the third light emitting area PXAb may be the same as each other, or at least two of the first light emitting area PXAr, the second light emitting area PXAg, and the third light emitting area PXAb may have different areas. FIG. 2 shows an example where the areas of the first light emitting area PXAr, the second light emitting area PXAg, and the third light emitting area PXAb are substantially the same.

The number of each of the light emitting diodes 101r, 101g, and 101b included in each of the light emitting diode units 100Ur, 100Ug, and 100Ub may vary according to a planar size of each of the light emitting areas PXAr, PXAg, and PXAb and a planar size of each of the light emitting diodes 101r, 101g, and 101b.

According to an embodiment, the number of first light emitting diodes 101r included in the first light emitting diode unit 100Ur may be greater than the number of third light emitting diodes 101b included in the third light emitting diode unit 100Ub. According to an embodiment, the number of second light emitting diodes 101g included in the second light emitting diode unit 100Ug may be greater than the number of third light emitting diodes 101b included in the third light emitting diode unit 100Ub. This may improve both luminance efficiency and reliability of light emitting diodes. The number of first light emitting diodes 101r included in the first light emitting diode unit 100Ur may be equal to or different from the number of second light emitting diodes 101g included in the second light emitting diode unit 100Ug. FIG. 2 illustrates an example in which the number of first light emitting diodes 101r included in the first light emitting diode unit 100Ur is the same as the number of second light emitting diodes 101g included in the second light emitting diode unit 100Ug, and for example, the number of the first light emitting diodes 101r included in the first light emitting diode unit 100Ur may be 9. FIG. 2 illustrates an example in which the number of third light emitting diodes 101b included in the third light emitting diode unit 100Ub is 1, but embodiments are not limited thereto. This may allow relative improvement of reliability of light emitting diodes.

The driving circuit portion 700 of each of the light emitting diode units 100Ur, 100Ug, and 100Ub may be disposed between each of the light emitting diodes 101r, 101g, and 101b and the substrate SUB, and may overlap each of the light emitting diodes 101r, 101g, and 101b corresponding to the driving circuit portion 700, e.g., in a plan view. The driving circuit portion 700 may include a driving circuit for driving the light emitting diodes 101r, 101g, and 101b. The driving circuit portion 700 may include a pixel circuit portion (e.g., the pixel circuit portion PXC) electrically connected to each of the light emitting diodes 101r, 101g, and 101b.

An area between the adjacent light emitting diode units 100Ur, 100Ug, and 100Ub or the adjacent pixels PXr, PXg, and PXb may include a wiring area SLA through which various signal lines or voltage lines pass.

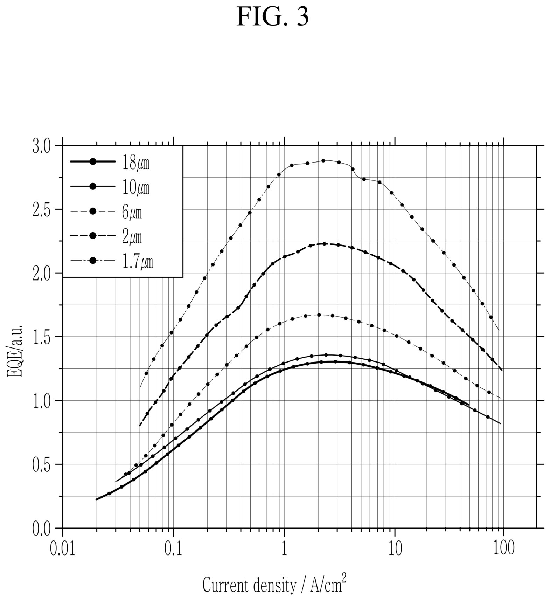

Referring to FIGS. 3 to 8 together with FIG. 2, characteristics of the first light emitting diode 101r, the second light emitting diode 101g, and the third light emitting diode 101b of the display device according to the embodiment and effects of the characteristics will now be described.

FIG. 3 is a graph showing external quantum efficiency according to a planar size of the light emitting diode. Each of 1.7, 2, 6, 10, and 18 micrometers described in FIG. 3 represents the planar size of the light emitting diode (e.g., the length of the shortest side (e.g., the shortest width)). Referring to FIG. 3, it may be seen that external quantum efficiency (EQE) of the light emitting diode does not significantly increase in case that the planar size (e.g., the shortest width) of the light emitting diode is about 10 micrometers or more but external quantum efficiency (EQE) noticeably increases in case that the planar size of the light emitting diode is less than about 10 micrometers and external quantum efficiency (EQE) significantly increases in case that the planar size of the light emitting diode becomes smaller than about 6 micrometers. External quantum efficiency (EQE) may be a value that is generally proportional to internal quantum efficiency (IQE) and a light extraction efficiency of the light emitting diode. As external quantum efficiency (EQE) is higher, light efficiency may be higher so that luminance efficiency of the light emitting diode may be higher.

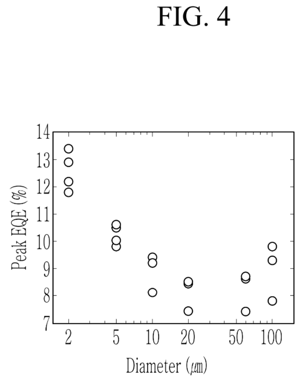

FIG. 4 is a graph showing a peak value of external quantum efficiency according to the planar size of the light emitting diode. FIG. 4 shows the plane size of the light emitting diode based on its diameter. Referring to FIG. 4, it may be confirmed that the peak value of external quantum efficiency (EQE) of the light emitting diode significantly increases in case that the planar size (e.g., the shortest width or the diameter) of the light emitting diode is less than about 10 micrometers.

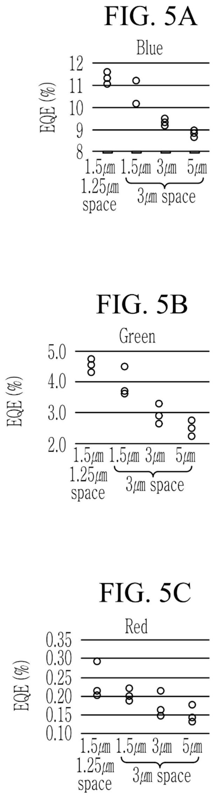

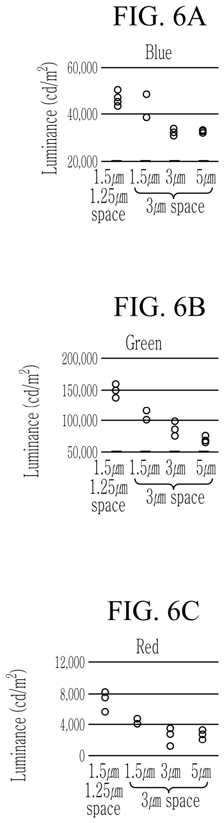

FIGS. 5A, 5B, and 5C are graphs showing external quantum efficiency according to a planar size of each of a red-light emitting diode, a green-light emitting diode, and a blue-light emitting diode, and FIGS. 6A, 6B, and 6C are graphs showing luminance according to the planar size of each of the red-light emitting diode, the green-light emitting diode, and the blue-light emitting diode. In FIGS. 5A, 5B, and 5C and FIGS. 6A, 6B, and 6C, each of 1.5, 1.5, 3, and 5 micrometers horizontally disposed represents the planar size of the light emitting diode (e.g., the length of the shortest side (e.g., the shortest width)), and each of 1.25 and 3 micrometer spaces described below each of 1.5, 1.5, 3, and 5 micrometers represents an interval between adjacent light emitting diodes. "Blue," "Green," and "Red" of FIG. 5A, FIG. 5B, FIG. 5C, FIG. 6A, FIG. 6B, and FIG. 6C each represent a blue-light emitting diode, a green-light emitting diode, and a red-light emitting diode. Referring to FIGS. 5A, 5B, and 5C and FIGS. 6A, 6B, and 6C, it may be seen that external quantum efficiency (EQE) and luminance continue to increase regardless of a color of the light emitting diode as the planar size (e.g., the shortest width) of the light emitting diode decreases in case that the planar size of the light emitting diode is about 5 micrometers or less.

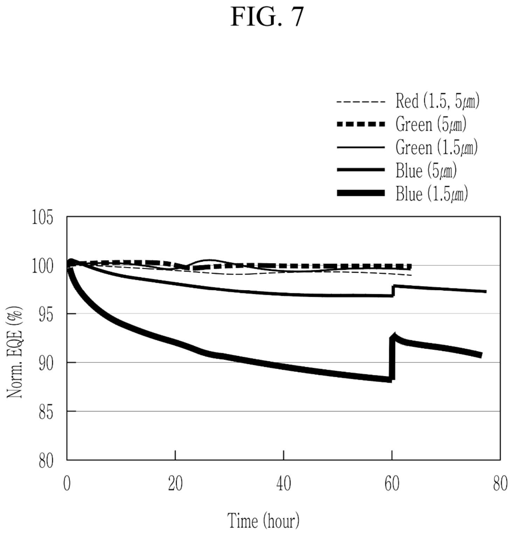

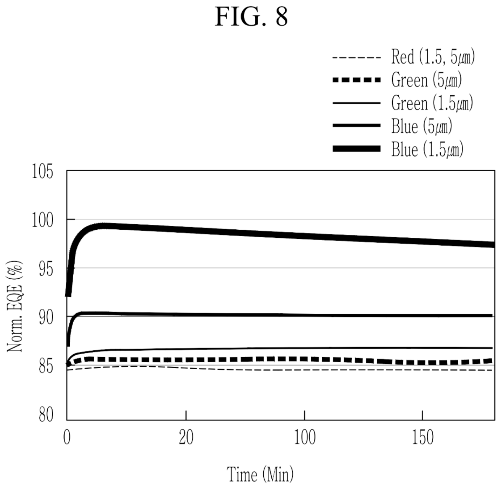

FIG. 7 is a graph showing a change in normalized external quantum efficiency over time for a red-light emitting diode, a green-light emitting diode, and a blue-light emitting diode of various planar sizes, and FIG. 8 is a graph showing a change in normalized external quantum efficiency over time of a red-light emitting diode, a green-light emitting diode, and a blue-light emitting diode of various planar sizes. FIG. 7 is a result of long-term reliability evaluation of the light emitting diode, and FIG. 8 is a result of short-term reliability evaluation of the light emitting diode after the long-term reliability evaluation. "Blue," "Green," and "Red" of FIG. 7 and FIG. 8 each represent a blue-light emitting diode, a green-light emitting diode, and a red-light emitting diode, and the numbers 1.5 and about 5 micrometers of FIG. 7 and FIG. 8 represent the planar size (e.g., the shortest width) of each light emitting diode.

Referring to FIG. 7, it may be seen that external quantum efficiency (EQE) of each of the green-light emitting diode and the red-light emitting diode with the planar size of about 1.5 or about 5 micrometers does not significantly change over time but external quantum efficiency of the blue-light emitting diode rapidly decreases over time as the planar size thereof decreases from about 5 micrometers to about 1.5 micrometers compared with the red-light emitting diode or the green-light emitting diode with the same size as that of the blue-light emitting diode. For example, it may be seen that long-term reliability of the blue-light emitting diode deteriorates very much in case that the planar size thereof is smaller than about 5 micrometers unlike the light emitting diode of another color.

Referring to FIG. 8, it may be seen that external quantum efficiency (EQE) of each of the green-light emitting diode and the red-light emitting diode with the planar size of about 1.5 or about 5 micrometers does not significantly change even for a short time after long-term operation thereof (e.g., after long-term reliability evaluation thereof) but external quantum efficiency of the blue-light emitting diode decreases over a short time as the planar size thereof decreases from about 5 micrometers to about 1.5 micrometers compared with the red-light emitting diode or the green-light emitting diode with the same size as that of the blue-light emitting diode. For example, it may be seen that short-term reliability of the blue-light emitting diode deteriorates in case that the planar size thereof is less than about 5 micrometers, unlike the light emitting diode of another color.

Based on data of external quantum efficiency according to the planar size of the light emitting diode shown in FIGS. 3 to 8, external quantum efficiency of each of the first light emitting diode 101r and the second light emitting diode 101g may continuously increase in case that the planar size thereof is smaller than about 10 micrometers and external quantum efficiency may be maximized in case that the planar size thereof is smaller than a reference size ranging from about 3 micrometers to about 5 micrometers, so it is possible to maximize light efficiency or luminance efficiency. In case that the planar size of each of the first light emitting diode 101r and the second light emitting diode 101g is smaller than the reference size ranging from about 3 micrometers to about 5 micrometers, there is no decrease in light efficiency or luminance efficiency over time (i.e., there is no decrease in reliability). Therefore, the planar size of each of the first light emitting diode 101r and the second light emitting diode 101g may be made less than the reference size ranging from about 3 micrometers to about 5 micrometers in the embodiment, so that it is possible to maximize light efficiency or luminance efficiency without lowering reliability.

If a planar size of the third light emitting diode 101b is less than about 10 micrometers, the third light emitting diode 101b may also continuously increase external quantum efficiency, but in case that a planar size of the third light emitting diode 101b is smaller than a reference size ranging from about 3 micrometers to about 5 micrometers, a decrease in light efficiency or luminance efficiency over time may be large so that reliability may be lowered. Therefore, the planar size of the third light emitting diode 101b may be made larger than or equal to a reference size ranging from about 3 micrometers to about 5 micrometers and may be made smaller than about 10 micrometers in the embodiment so that reliability over time may be increased while increasing light efficiency or luminance efficiency.

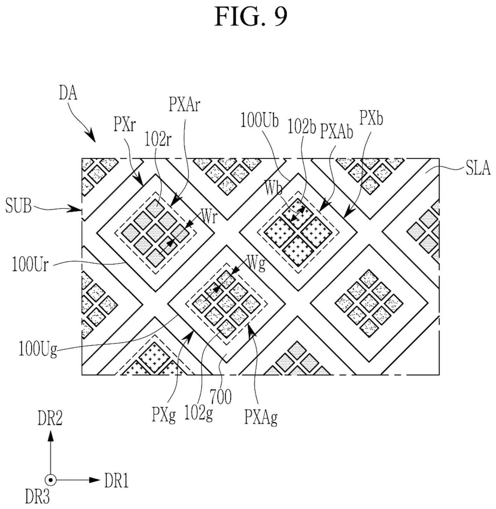

A display device according to an embodiment will be described with reference to FIG. 9 together with the drawings described above. A description of a structure and a characteristic of the embodiment of FIG. 9 that are the same as those of the above-described embodiment will be omitted.

FIG. 9 is a schematic plan view of a display portion of the display device according to the embodiment.

Referring to FIG. 9, the display device according to the embodiment may be mostly the same as the display device illustrated in FIG. 2 described above, but a first light emitting diode unit 100Ur disposed at a display portion DA may include at least one first light emitting diode 102r and a driving circuit portion 700 connected to the first light emitting diode 102r, a second light emitting diode unit 100Ug disposed at the display portion DA may include at least one second light emitting diode 102g and a driving circuit portion 700 connected to the second light emitting diode 102g, and a third light emitting diode unit 100Ub disposed at the display portion DA may include at least one third light emitting diode 102b and a driving circuit portion 700 connected to the third light emitting diode 102b.

The first light emitting diode 102r may have the same characteristic as that of the first light emitting diode 101r described above, the second light emitting diode 102g may have the same characteristic as that of the second light emitting diode 101g described above, and the third light emitting diode 102b may have the same characteristic as that of the third light emitting diode 101b described above. However, unlike the embodiment illustrated in FIG. 2 described above, FIG. 9 illustrates an example in which the number of third light emitting diodes 102b included in the third light emitting diode unit 100Ub is provided in plurality (e.g., 4). This may allow relative improvement of luminance efficiency of light emitting diodes.

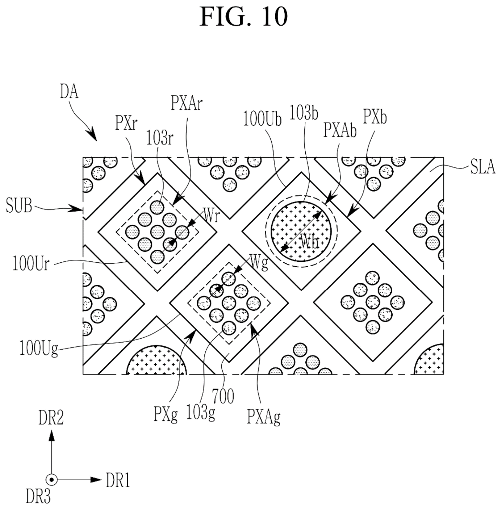

A display device according to an embodiment will be described with reference to FIG. 10 together with the drawings described above. A description of a structure and a characteristic of the embodiment of FIG. 10 that are the same as those of the above-described embodiment will be omitted.

FIG. 10 is a schematic plan view of a display portion of the display device according to the embodiment.

Referring to FIG. 10, the display device according to the embodiment may be mostly the same as the display device illustrated in FIG. 2 described above, but a first light emitting diode unit 100Ur disposed at the display portion DA may include at least one first light emitting diode 103r and a driving circuit portion 700 connected to the first light emitting diode 103r, a second light emitting diode unit 100Ug disposed at the display portion DA may include at least one second light emitting diode 103g and a driving circuit portion 700 connected to the second light emitting diode 103g, and a third light emitting diode unit 100Ub disposed at the display portion DA may include at least one third light emitting diode 103b and a driving circuit portion 700 connected to the third light emitting diode 103b.

The first light emitting diode 103r may be mostly the same as the first light emitting diode 101r described above, but may have a circular planar shape. The second light emitting diode 103g may be mostly the same as the second light emitting diode 101g described above, but may have a circular planar shape. The third light emitting diode 103b may be mostly the same as the third light emitting diode 101b described above, but may have a circular planar shape.

A shortest width Wb (e.g., a diameter) of the third light emitting diode 103b may be greater than or equal to a reference size, and at least one of a shortest width Wr (e.g., a diameter) of the first light emitting diode 103r and a shortest width Wg (e.g., a diameter) of the second light emitting diode 103g may be less than the reference size. The reference size may be determined within a range of about 3 micrometers to about 5 micrometers, and if further limited, the reference size may be determined to be about 3 micrometers. For example, the shortest width Wb (e.g., the diameter) of the third light emitting diode 103b may be about 3 micrometers or more, and each of the shortest width Wr (e.g., the diameter) of the first light emitting diode 103r and the shortest width Wg (e.g., the diameter) of the second light emitting diode 103g may be less than about 3 micrometers. The shortest width Wb (e.g., the diameter) of the third light emitting diode 103b may be less than about 10 micrometers.

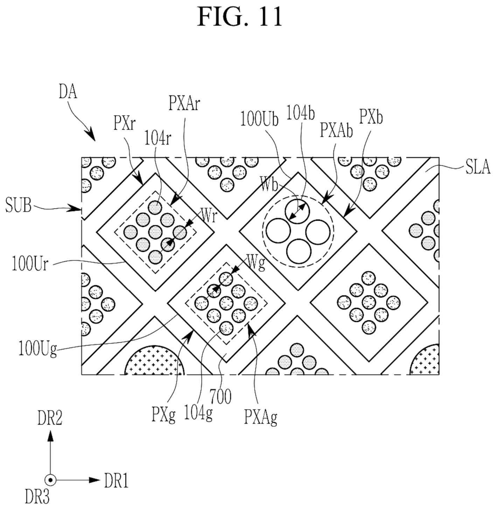

A display device according to an embodiment will be described with reference to FIG. 11 together with the drawings described above. A description of a structure and a characteristic of the embodiment of FIG. 10 that are the same as those of the above-described embodiment will be omitted.

FIG. 11 is a plan view of a display portion of the display device according to the embodiment.

Referring to FIG. 11, the display device according to the embodiment may be mostly the same as the display device illustrated in FIG. 10 described above, but a first light emitting diode unit 100Ur disposed at a display portion DA may include at least one first light emitting diode 104r and a driving circuit portion 700 connected to the first light emitting diode 104r, a second light emitting diode unit 100Ug disposed at the display portion DA may include at least one second light emitting diode 104g and a driving circuit portion 700 connected to the second light emitting diode 104g, and a third light emitting diode unit 100Ub disposed at the display portion DA may include at least one third light emitting diode 104b and a driving circuit portion 700 connected to the third light emitting diode 104b.

The first light emitting diode 104r may have the same characteristic as that of each of the first light emitting diodes 101r, 102r, and 103r described above, the second light emitting diode 104g may have the same characteristic as that of each of the second light emitting diodes 101g, 102g, and 103g described above, and the third light emitting diode 104b may have the same characteristic as that of each of the third light emitting diodes 101b, 102b, and 103b described above. However, unlike the embodiment illustrated in FIG. 10 described above, FIG. 11 illustrates an example in which the number of third light emitting diodes 104b included in the third light emitting diode unit 100Ub is provided in plurality (e.g., 4). This may allow relative improvement luminance efficiency light emitting diodes.

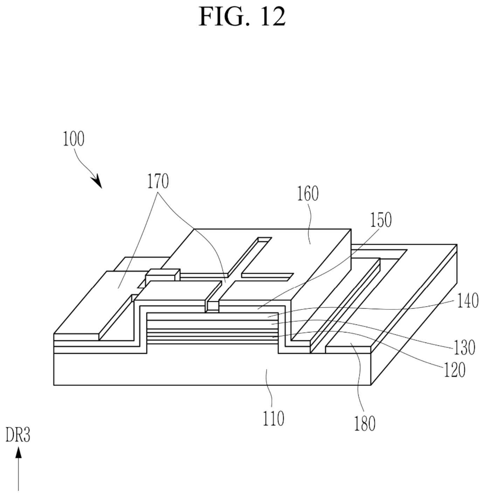

A display device according to an embodiment will be described with reference to FIG. 12 together with the foregoing drawings.

FIG. 12 is a schematic perspective view showing a cross-section of a light emitting diode according to an embodiment.

The light emitting diode 100 included in a display device according to an embodiment may be a micro-light emitting diode (or an ultra-small light emitting diode) having a planar size of about 10 micrometers or less.

The light emitting diode 100 according to the embodiment may have an epitaxial structure grown on a substrate. For example, the light emitting diode 100 may be formed by being grown on a semiconductor substrate such as a silicon wafer. For example, the light emitting diode 100 may include a first semiconductor layer 110, an active layer 120 above the first semiconductor layer 110, and a second semiconductor layer 130 above the active layer 120.

Each of the first semiconductor layer 110 and the second semiconductor layer 130 may include a Group II-VI compound semiconductor material or a Group III-V compound semiconductor material (e.g., a nitride semiconductor material). For example, each of the first semiconductor layer 110 and the second semiconductor layer 130 may include at least one nitride semiconductor material among InAlGaN, GaN, AlGaN, InGaN,AIN, and InN. Each of the first semiconductor layer 110 and the second semiconductor layer 130 may serve to provide an electron and a hole to the active layer 120. For this purpose, the first semiconductor layer 110 may be doped with a first conductivity type dopant, and the second semiconductor layer 130 may be doped with a second conductivity type dopant that is electrically opposite to the first conductivity type dopant. For example, the first semiconductor layer 110 may be doped with an n-type dopant and the second semiconductor layer 130 may be doped with a p-type dopant, or conversely, the first semiconductor layer 110 may be doped with a p-type dopant and the second semiconductor layer 130 may be doped with an n-type dopant. The first semiconductor layer 110 or the second semiconductor layer 130 doped with an n-type dopant may provide an electron to the active layer 120, and the second semiconductor layer 130 or the first semiconductor layer 110 doped with a p-type dopant may provide a hole to the active layer 120.

The active layer 120 may be disposed between the first semiconductor layer 110 and the second semiconductor layer 130. The active layer 120 may have at least one quantum well structure in which a quantum well is disposed between barriers. As the electron and the hole provided from the first semiconductor layer 110 and the second semiconductor layer 130 are recombined within the quantum well of the active layer 120, light may be generated. A wavelength of light generated from the active layer 120 may be determined according to an energy band gap of a material constituting the quantum well within the active layer 120. The active layer 120 may have only one quantum well, but may have a multi-quantum well (MQW) structure in which quantum wells and barriers are alternately disposed. The active layer 120 may include a Group II-VI or a Group III-V compound semiconductor material (e.g., a nitride semiconductor material). For example, the active layer 120 may include at least one nitride semiconductor material among InGaN, GaN, AlGaN, and AlInGaN.

Colors represented by each of the first light emitting diodes 101r, 102r, 103r, and 104r, each of the second light emitting diodes 101g, 102g, 103g, and 104g, and each of the third light emitting diodes 101b, 102b, 103b, and 104b of the above-described embodiment may vary according to a type and a ratio of a material included in the active layer 120, or a material composition of each of the first semiconductor layer 110 and the second semiconductor layer 130.

The light emitting diode 100 may further include a current diffusion layer 140, at least one insulating layer 150 and 160, a first electrode 170, and a second electrode 180.

The current diffusion layer 140 may be disposed on the second semiconductor layer 130, and may be electrically connected to the first electrode 170 to perform a function of diffusing an electric current from the first electrode 170 to a wider area. The current diffusion layer 140 may include a conductive material such as ITO, TCO, or IZO. In another example, the current diffusion layer 140 may be omitted.

The first semiconductor layer 110, the active layer 120, the second semiconductor layer 130, and the current diffusion layer 140 may have a vertical stacking structure in the third direction DR3.

The at least one insulating layer 150 and 160 may include the first insulating layer 150 including a nitride material such as aluminum nitride, and/or the second insulating layer 160 including an oxide material such as silicon oxide. The first insulating layer 150 may be in contact with a side surface (SW) and an upper surface of the vertical stack structure of the first semiconductor layer 110, the active layer 120, the second semiconductor layer 130, and the current diffusion layer 140. A ratio of electrons, holes, or photons exiting through the side surface (SW) may vary according to a degree of damage to the side surface (SW) of the vertical stacking structure and an interval between facing side surfaces (SW) of the vertical stacking structure. Each of the first insulating layer 150 and the second insulating layer 160 may be formed by at least one method selected from sputtering deposition, atomic layer deposition (ALD), chemical vapor deposition (CVD), physical vapor deposition (PVD), plasma enhanced atom layer deposition (PEALD), plasma enhanced chemical vapor deposition (PECVD), and a combination thereof.

The first electrode 170 may be electrically connected to the second semiconductor layer 130, and the second electrode 180 may be electrically connected to the first semiconductor layer 110. A driving voltage may be applied between the first electrode 170 and the second electrode 180, so light may be emitted from the active layer 120 of the light emitting diode 100. The first electrode 170 and the second electrode 180 may be insulated from each other. The first electrode 170 may be an anode of the light emitting diode 100 and the second electrode 180 may be a cathode of the light emitting diode 100, or vice versa.

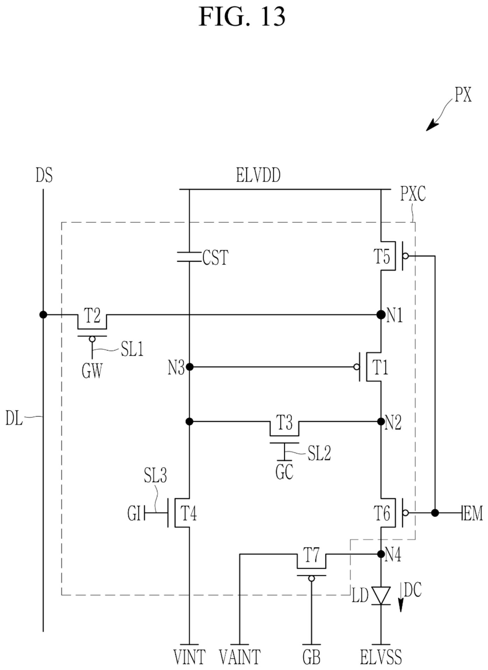

An example of a structure of a pixel included in a display device according to an embodiment will be described with reference to FIG. 13 together with the foregoing drawings.

FIG. 13 is a schematic diagram of an equivalent circuit of a pixel of the display device according to the embodiment.

Referring to FIG. 13, a pixel PX may include a pixel circuit portion PXC and a light emitting element LD.

The pixel circuit portion PXC may be connected to scan lines SL1, SL2, and SL3 and the data line DL. A first scan signal GW may be applied to the first scan line SL1, a second scan signal GC may be applied to the second scan line SL2, and a third scan signal GI may be applied to the third scan line SL3. A data signal (or a data voltage) DS may be applied to the data line DL.

The pixel circuit portion PXC may include transistors and at least one capacitor. The transistors according to an embodiment may include a first transistor T1, a second transistor T2, a third transistor T3, a fourth transistor T4, a fifth transistor T5, a sixth transistor T6, and a seventh transistor T7, and the at least one capacitor may include a storage capacitor CST.

A first electrode of the first transistor T1 may be connected to a first node N1, and a second electrode of the first transistor T1 may be connected to a second node N2. A gate electrode of the first transistor T1 may be connected to a third node N3. The first transistor T1 may generate a driving current DC based on a voltage between the third node N3 and the first node N1. The first transistor T1 may be referred to as a driving transistor.

A first electrode of the second transistor T2 may be connected to the data line DL, and a second electrode of the second transistor T2 may be connected to the first node N1. A gate electrode of the second transistor T2 may be connected to the first scan line SL1 that transmits the first scan signal GW. The second transistor T2 may write the data signal DS in the first node N1 in response to the first scan signal GW.

A first electrode of the third transistor T3 may be connected to the second node N2, and a second electrode of the third transistor T3 may be connected to the third node N3. A gate electrode of the third transistor T3 may be connected to the second scan line SL2 that transmits the second scan signal GC. The third transistor T3 may electrically connect the second electrode and the gate electrode of the first transistor T1 in response to the second scan signal GC.

A first electrode of the fourth transistor T4 may be connected to a first initialization voltage line that transmits a first initialization voltage VINT, and a second electrode of the fourth transistor T4 may be connected to the third node N3. A gate electrode of the fourth transistor T4 may be connected to the third scan line SL3 that transmits the third scan signal GI. The fourth transistor T4 may initialize the third node N3 with the first initialization voltage VINT in response to the third scan signal GI.

A first electrode of the fifth transistor T5 may be connected to a driving voltage line that transmits a driving voltage ELVDD, and a second electrode of the fifth transistor T5 may be connected to the first node N1. A gate electrode of the fifth transistor T5 may be connected to a light emitting control line that transmits a light emitting control signal EM. The fifth transistor T5 may electrically connect the driving voltage line and the first node N1 in response to the light emitting control signal EM.

A first electrode of the sixth transistor T6 may be connected to the second node N2, and a second electrode of the sixth transistor T6 may be connected to a fourth node N4. A gate electrode of the sixth transistor T6 may be connected to the light emitting control line. The sixth transistor T6 may electrically connect the second node N2 and the fourth node N4 in response to the light emitting control signal EM.

A first electrode of the seventh transistor T7 may be connected to a second initialization voltage line that transmits a second initialization voltage VAINT, and a second electrode of the seventh transistor T7 may be connected to the fourth node N4. A gate electrode of the seventh transistor T7 may be connected to a scan line that transmits a scan signal GB. The scan line transmitting the scan signal GB may be the third scan line SL3 of a previous stage, and the scan signal GB may be the third scan signal GI of a previous stage. The seventh transistor T7 may initialize the fourth node N4 with the second initialization voltage VAINT in response to the scan signal GB.

A first electrode of the storage capacitor CST may be connected to the third node N3, and a second electrode of the storage capacitor CST may be connected to the driving voltage line. The storage capacitor CST may store a voltage of the third node N3.

A first electrode of the light emitting element LD may be connected to the fourth node N4, and a second electrode of the light emitting element LD may be connected to a common voltage line that transmits a common voltage ELVSS. The light emitting element LD may emit light based on the driving current DC. The light emitting element LD may emit light with a luminance corresponding to the driving current DC. The light emitting element LD may include at least one light emitting diode according to the embodiment described above.

A structure of the pixel circuit portion PXC according to an embodiment is not limited thereto, and the number of transistors and capacitors, the connection relationship, and the like may be variously changed.

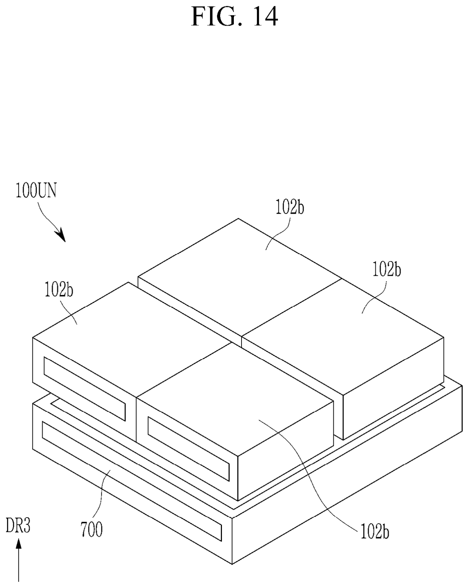

A light emitting diode unit included in a display device according to an embodiment will be described with reference to FIG. 14 together with the drawings described above.

FIG. 14 is a schematic perspective view of a light emitting diode unit of the display device according to the embodiment.

A light emitting diode unit 100UN according to the embodiment may be any of the light emitting diode units 100Ur, 100Ug, and 100Ub described above. FIG. 14 illustrates an example in which the light emitting diode unit 100UN is the light emitting diode unit 100Ub including the third light emitting diodes 102b and the driving circuit portion 700 shown in FIG. 9. The light emitting diode unit 100Ub may be implemented in a form of one chip of the light emitting diode unit 100UN.

The driving circuit portion 700 may include the pixel circuit portion PXC described above. The driving circuit portion 700 may include pixel circuit portions PXC each connected to light emitting diodes. However, in contrast to this, the number of pixel circuit portions included in the driving circuit portion 700 and the number of light emitting diodes included in one light emitting diode unit 100UN may be different from each other.

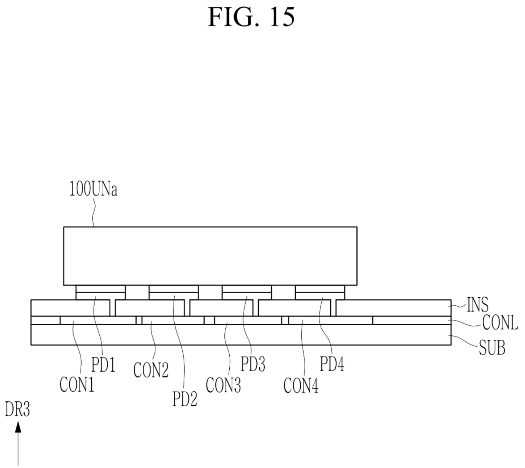

A display device according to an embodiment will be described with reference to FIG. 15 together with the drawings described above.

FIG. 15 is a cross-sectional view of the display device according to the embodiment.

Referring to FIG. 15, the display device according to the embodiment may include a substrate SUB, and at least one conductive layer CONL and at least one insulating layer INS may be stacked above or on the substrate SUB. The at least one conductive layer CONL and the at least one insulating layer INS may be patterned so that at least a portion thereof may be removed. For example, the conductive layer CONL may be patterned to include conductors CON1, CON2, CON3, and CON4.

Pad electrodes PD1, PD2, PD3, and PD4 may be disposed above or on the at least one conductive layer CONL and the at least one insulating film INS. The pad electrodes PD1, PD2, PD3, and PD4 may each be electrically connected to the conductors CON1, CON2, CON3, and CON4 of the conductive layer CONL through openings of the insulating film INS.

A light emitting diode unit 100UNa may be installed above the pad electrodes PD1, PD2, PD3, and PD4. The light emitting diode unit 100UNa may be each of light emitting diode units 100Ur, 100Ug, 100Ub, and 100UN according to the embodiment described above. The light emitting diode unit 100UNa may include at least one light emitting diode and a driving circuit portion 700. The driving circuit portion 700 may be electrically connected to each of the pad electrodes PD1, PD2, PD3, and PD4 to receive a signal and a voltage required for driving the light emitting diode. The driving circuit portion 700 may include the pixel circuit portion PXC described above.

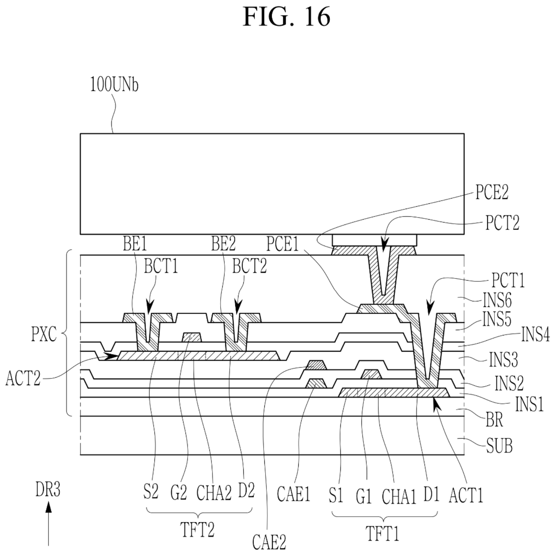

A display device according to an embodiment will be described with reference to FIG. 16 together with the drawings described above.

FIG. 16 is a cross-sectional view of the display device according to the embodiment.

Referring to FIG. 16, the display device according to the embodiment may include the substrate SUB, and a barrier film BR may be disposed on the substrate SUB. The substrate SUB may be made of an insulating material such as a polymer resin. The barrier film BR may protect an upper layer from moisture penetrating through the substrate SUB. The barrier film BR may include inorganic films alternately stacked.

A first transistor TFT1 may be disposed on the barrier film BR. The first transistor TFT1 may be a transistor connected to the fourth node N4 like the sixth transistor T6 and the seventh transistor T7 shown in FIG. 13.

The first transistor TFT1 may include a first active layer ACT1 disposed on the barrier film BR and a first gate electrode G1. The first active layer ACT1 may include one of polycrystalline silicon, monocrystalline silicon, low-temperature polycrystalline silicon, and amorphous silicon. The first active layer ACT1 may include a first channel area CHA1, a first source area S1, and a first drain area D1. The first channel area CHA1 may be an area that overlaps the first gate electrode G1 in the third direction DR3. Each of the first source area S1 and the first drain area D1 may be an area in which an ion is doped into a semiconductor material to provide conductivity.

A first insulating film INS1 may be disposed on the first active layer ACT1. A first conductive layer including the first gate electrode G1 and a first capacitor electrode CAE1 may be disposed on the first insulating film INS1.

A second insulating film INS2 may be disposed on the first conductive layer. A second conductive layer including a second capacitor electrode CAE2 may be disposed on the second insulating film INS2. The second capacitor electrode CAE2 may overlap the first capacitor electrode CAE1 in the third direction DR3 to form a capacitor (e.g., the storage capacitor CST shown in FIG. 13).

A third insulating film INS3 may be disposed on the second conductive layer. A second transistor TFT2 may be disposed on the third insulating film INS3. The second transistor TFT2 may be one of the fourth transistor T4 and the third transistor T3 shown in FIG. 13.

The second transistor TFT2 may include a second active layer ACT2 and a second gate electrode G2. The second active layer ACT2 may include an oxide semiconductor such as IGZO, IGZTO, or IGTO. The second active layer ACT2 may include a second channel area CHA2, a second source area S2, and a second drain area D2. The second channel area CHA2 may be an area that overlaps the second gate electrode G2 in the third direction DR3. Each of the second source area S2 and the second drain area D2 may be an area in which an ion is doped into an oxide semiconductor to provide conductivity.

A fourth insulating film INS4 may be disposed on the second active layer ACT2. A third conductive layer including the second gate electrode G2 may be disposed on the fourth insulating film INS4.

A fifth insulating film INS5 may be disposed on the third conductive layer. A fourth conductive layer including connection electrodes BE1, BE2, and PCE1 may be disposed on the fifth insulating film INS5. The connection electrode PCE1 may be connected to the first drain area D1 of the first active layer ACT1 through an opening PCT1 of each of the insulating films INS1, INS2, INS3, INS4, and INS5. The connection electrode BE1 may be connected to the second source area S2 of the second active layer ACT2 through an opening BCT1 of each of the insulating films INS4 and INS5. The connection electrode BE2 may be connected to the second drain area D2 of the second active layer ACT2 through an opening BCT2 of each of the insulating films INS4 and INS5.

At least one of the first insulating film INS1, the second insulating film INS2, the third insulating film INS3, the fourth insulating film INS4, and the fifth insulating film INS5 may include an inorganic insulating material such as silicon oxide, silicon nitride, silicon oxynitride, or aluminum oxide.

A sixth insulating film INS6 may be disposed on the fourth conductive layer. The sixth insulating film INS6 may include an organic insulating material such as an acrylic resin, an epoxy resin, a phenolic resin, a polyamide resin, or a polyimide resin.

A fifth conductive layer including at least one pad electrode PCE2 may be disposed on the sixth insulating film INS6. The pad electrode PCE2 may be connected to the connection electrode PCE1 through an opening PCT2 of the sixth insulating film INS6.

At least one of the first conductive layer, the second conductive layer, the third conductive layer, the fourth conductive layer, and the fifth conductive layer may be formed as a single layer or multiple layers including at least one metal such as molybdenum (Mo), aluminum (Al), chromium (Cr), gold (Au), titanium (Ti), nickel (Ni), neodymium (Nd), or copper (Cu).

A light emitting diode unit 100UNb may be installed on the pad electrode PCE2. The light emitting diode unit 100UNb may be each of the light emitting diode units 100Ur, 100Ug, 100Ub, and 100UN according to the embodiment described above. The light emitting diode unit 100UNb may include at least one light emitting diode and the driving circuit portion 700. The driving circuit portion 700 may be electrically connected to at least one pad electrode PCE2 to receive a signal and a voltage required for driving the light emitting diode. The transistors including the first and second transistors TFT1 and TFT2 formed on the substrate SUB and the capacitor may form the pixel circuit portion PXC described above. The light emitting diode of the light emitting diode unit 100UNb may receive a voltage to be applied to an anode through the pad electrode PCE2.

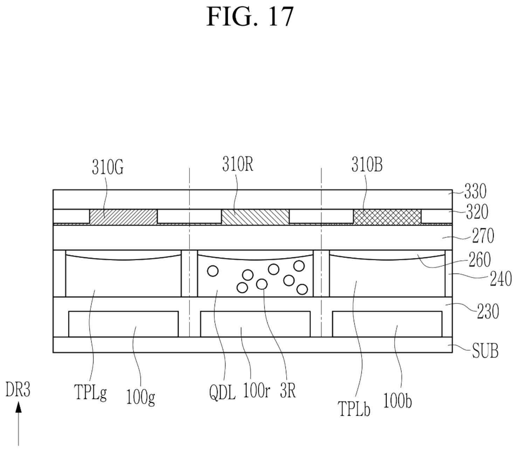

A display device according to an embodiment will be described with reference to FIG. 17 together with the drawings described above.

FIG. 17 is a schematic cross-sectional view of the display device according to the embodiment.

The display device according to the embodiment may include the substrate SUB, and each of light emitting diodes 100r, 100g, and 100b may be disposed on the substrate SUB. The light emitting diode 100g may be the same as each of the second light emitting diodes 101g, 102g, 103g, and 104g described above, and may emit green light. The light emitting diode 100b may be the same as each of the first light emitting diodes 101r, 102r, 103r, and 104r (see FIGS. 2, 9, 10, and 11) described above, and may emit red light. The light emitting diode 100r may be the same as each of the third light emitting diodes 101b, 102b, 103b, and 104b described above, and may emit blue light.

A protective layer 230 may be disposed on each of the light emitting diodes 100r, 100g, and 100b. The protective layer 230 may include at least one of an inorganic material such as silicon oxide or silicon nitride and an organic material.

A color conversion layer QDL and transmissive layers TPLg and TPLb may be disposed on the protective layer 230.

The transmissive layers TPLg and TPLb may be disposed above the light emitting diodes 100g and 100b to overlap each other in the third direction DR3, and the transmissive layers TPLg and TPLb may pass light incident from the light emitting diodes 100g and 100b. The transmissive layers TPLg and TPLb may include a polymer material. In another example, the transmissive layers TPLg and TPLb may be omitted.

The color conversion layer QDL may be disposed to overlap the light emitting diode 100r in the third direction DR3. The color conversion layer QDL may include a semiconductor nanocrystal. The semiconductor nanocrystal may include a quantum dot 3R that converts incident light (e.g., blue light) into light of another color (e.g., red light). The quantum dot 3R may include a Group II-VI compound, a Group III-V compound, a Group IV-VI compound, a Group IV element or compound, a Group I-III-VI compound, a Group II-III-VI compound, a Group I-II-IV-VI compound, or a combination thereof. The quantum dot may not include cadmium. According to the embodiment, the quantum dot 3R may have a core-shell structure including a core including the nanocrystal described above and a shell surrounding the core. The shell of the quantum dot may serve as a protective layer for maintaining a semiconductor characteristic by preventing chemical denaturation of the core and/or a charging layer for imparting an electrophoretic characteristic to the quantum dot. The shell may be a single layer or multiple layers. An interface between the core and the shell may have a concentration gradient in which a concentration of an element present in the shell decreases toward a center thereof. For example, the shell of the quantum dot may include a metal oxide, a non-metal oxide, a semiconductor compound, or a combination thereof. The quantum dot 3R may emit light converted into red light, and for example, a maximum light emitting peak wavelength of the quantum dot 3R may be about 600 nm or more, about 610 nm or more, about 615 nm or more, or about 620 nm or more and about 650 nm or less, about 645 nm or less, about 640 nm or less, about 635 nm or less, or about 630 nm or less.

A partition wall 240 may be disposed between the adjacent color conversion layer QDL and each of the transmissive layers TPLg and TPLb.

An overcoat layer 260 may be disposed on the color conversion layer QDL and each of the transmissive layers TPLg and TPLb. In another example, the overcoat layer 260 may be omitted.

An insulating layer 270 may be disposed on the overcoat layer 260 and the partition wall 240, and color filters 310R, 310G, and 310B and a light blocking member 320 may be disposed on the insulating layer 270. The color filter 310R may display red light, the color filter 310G may display green light, and the color filter 310B may display blue light.

A substrate or an insulating layer 330 may be disposed on the color filters 310R, 310G, and 310B and the light blocking member 320.

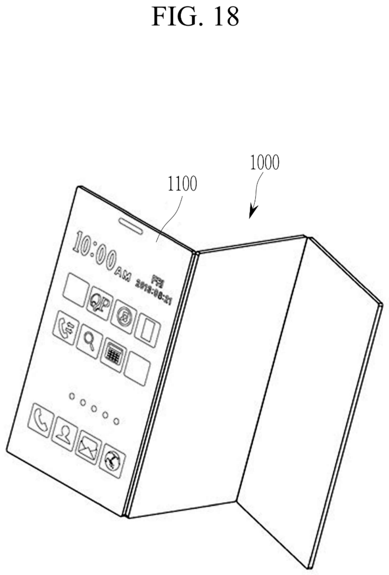

Various electronic devices to which a display device according to an embodiment is applied will be described with reference to FIGS. 18 to 21 together with the drawings described above.

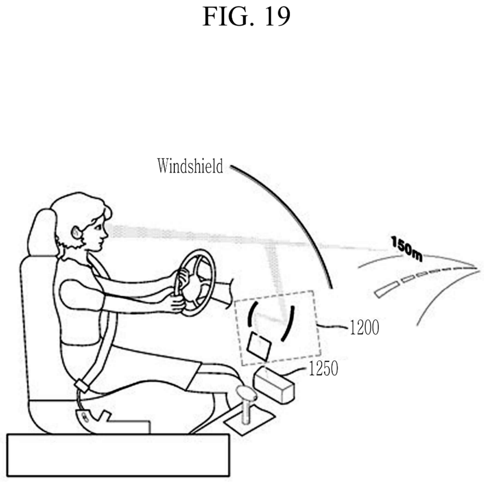

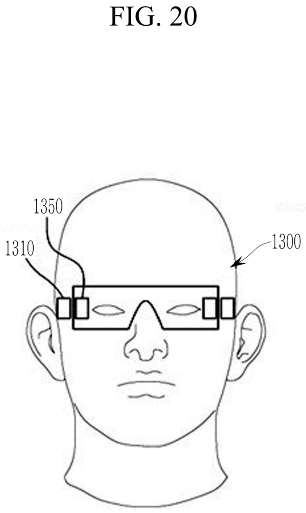

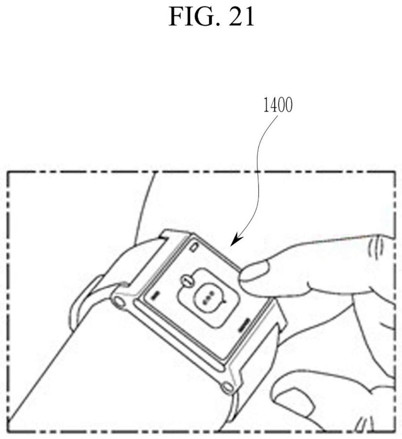

FIG. 18 illustrates an example in which a display device according to an embodiment is applied to a mobile device, FIG. 19 illustrates an example in which a display device according to an embodiment is applied to a display device for a vehicle, FIG. 20 illustrates an example in which a display device according to an embodiment is applied to augmented reality glasses or virtual reality glasses, and FIG. 21 illustrates an example in which a display device according to an embodiment is applied to a wearable display device.

Referring to FIG. 18, an electronic device according to an embodiment may be a mobile device 1000, and may include a display device 1100 according to the embodiment described above. The display device 1100 may have a structure in which at least a portion thereof may be folded, and for example, the display device 1100 may be implemented as a multi-foldable display device. For example, the display device 1100 may be implemented as a rollable display device, a curved display device, a stretchable display device, or the like.

Referring to FIG. 19, for example, an electronic device according to an embodiment may include a head-up display device for a vehicle. The head-up display device may include a display device 1250 provided in an area of the vehicle, and at least one light path changing member 1200 that changes a path of light so that a driver of the vehicle may see an image generated by the display device 1250. The display device 1250 may include the display device according to the embodiment described above.

Referring to FIG. 20, an electronic device according to an embodiment may be the augmented reality glasses or the virtual reality glasses 1300, and may include a projection system 1310 for forming an image and at least one member 1350 for guiding the image from the projection system 1310 to enter a user's eye. The projection system 1310 may include the display device according to the embodiment described above.

Referring to FIG. 21, an electronic device according to an embodiment may be a wearable device 1400, and may include the display device according to the embodiment described above.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display device comprising:
a substrate (SUB); and
a first light emitting diode unit (100Ur), a second light emitting diode unit (100Ug), and a third light emitting diode unit (100Ub) that are disposed above the substrate (SUB), wherein
the first light emitting diode unit (100Ur) includes at least one first light emitting diode (101r, 102r, 103r, 104r) emitting a first color light,
the second light emitting diode unit (100Ug) includes at least one second light emitting diode (101g, 102g, 103g, 104g) emitting a second color light different from the first color light,
the third light emitting diode unit (100Ub) includes at least one third light emitting diode (101b, 102b, 103b, 104b) emitting a third color light different from the first color light and the second color light, and
a planar size of the at least one third light emitting diode (101b, 102b, 103b, 104b) is greater than a planar size of the at least one first light emitting diode (101r, 102r, 103r, 104r) and a planar size of the at least one second light emitting diode (101g, 102g, 103g, 104g).

2. The display device of claim 1, wherein a shortest width (Wb) of the at least one third light emitting diode (101b, 102b, 103b, 104b) in a plan view is greater than a shortest width (Wr) of the at least one first light emitting diode (101r, 102r, 103r, 104r) in the plan view and a shortest width (Wg) of the at least one second light emitting diode (101g, 102g, 103g, 104g) in the plan view.

3. The display device of claim 2, wherein
the shortest width (Wb) of the at least one third light emitting diode (101b, 102b, 103b, 104b) is greater than or equal to a reference size, and
at least one of the shortest width (Wr) of the at least one first light emitting diode (101r, 102r, 103r, 104r) and the shortest width (Wg) of the at least one second light emitting diode (101g, 102g, 103g, 104g) is less than the reference size.

4. The display device of claim 3, wherein the reference size is within a range of 3 micrometers to 5 micrometers.

5. The display device of any one of the preceding claims 1 to 4, wherein the shortest width (Wg) of the at least one third light emitting diode (101b, 102b, 103b, 104b) is less than 10 micrometers.

6. The display device of any one of the preceding claims 1 to 5, wherein at least one of the number of the at least one first light emitting diode (101r, 102r, 103r, 104r) included in the first light emitting diode unit (100Ur) and the number of the at least one second light emitting diode (101g, 102g, 103g, 104g) included in the second light emitting diode unit (100Ug) is greater than the number of the at least one third light emitting diode (101b, 102b, 103b, 104b) included in the third light emitting diode unit (100Ub).

7. The display device of any one of the preceding claims 1 to 6, wherein the first light emitting diode unit (100Ur) includes at least one red-light emitting diode (101r, 102r, 103r, 104r),
the second light emitting diode unit (100Ug) includes at least one green-light emitting diode (101g, 102g, 103g, 104g), and
the third light emitting diode unit (100Ub) includes at least one blue-light emitting diode (101b, 102b, 103b, 104b).

8. The display device of any one of the preceding claims 1 to 7, further comprising:
a driving circuit portion (700) that is disposed between each of the first light emitting diode unit (100Ur), the second light emitting diode unit (100Ug), the third light emitting diode unit (100Ub), and the substrate (SUB).

9. The display device of claim 8, further comprising:
a pixel circuit portion (PXC) electrically connected to at least one first electrode (170) of the at least one first light emitting diode (101r, 102r, 103r, 104r), the at least one second light emitting diode (101g, 102g, 103g, 104g), and the at least one third light emitting diode (101b, 102b, 103b, 104b),
wherein the pixel circuit portion (PXC) includes a plurality of transistors.

10. The display device of claim 9, wherein the driving circuit portion (700) includes the pixel circuit portion (PXC).

11. The display device of claim 9, wherein the pixel circuit portion (PXC) is disposed between the substrate (SUB) and the driving circuit portion (700).

12. The display device of any one of the preceding claims 1 to 11, wherein a planar shape of at least one of the at least one first light emitting diode (101r, 102r, 103r, 104r), the at least one second light emitting diode (101g, 102g, 103g, 104g), and the at least one third light emitting diode (101b, 102b, 103b, 104b) is a circle or a rectangle.

13. The display device of any one of the preceding claims 1 to 12, wherein the second light emitting diode unit (100Ug) includes at least one green-light emitting diode (101g, 102g, 103g, 104g),
the third light emitting diode unit (100Ub) includes at least one blue-light emitting diode (101b, 102b, 103b, 104b),
the shortest width (Wb) of the at least one blue-light emitting diode (101b, 102b, 103b, 104b) in a plan view is 3 micrometers or more, and
the shortest width (Wg) of the at least one green-light emitting diode (101g, 102g, 103g, 104g) in the plan view is less than 3 micrometers.

14. The display device of claim 13, wherein the shortest width (Wg) of the at least one green-light emitting diode (101g, 102g, 103g, 104g) is less than 10 micrometers.

15. An electronic device, comprising a display device according to any one of the preceding claims 1 to 14.
